# EUROPEAN PATENT SPECIFICATION

(11) **EP 3 349 023 B1**
(45) Date of publication and mention of the grant of the patent: **23.10.2019**
(21) Application number: 17290002.9
(22) Date of filing: 16.01.2017
(51) Int. Cl.: G01R 31/12, H02B 13/065, H02H 1/00

(54) **A PARTIAL DISCHARGE DETECTION ARRANGEMENT AND COMBINED MODULE THEREFOR**
TEILENTLADUNGSDETEKTIONSANORDNUNG UND KOMBINIERTES MODUL DAFÜR
AGENCEMENT DE DÉTECTION DE DÉCHARGE PARTIELLE ET SON MODULE COMBINÉ

(43) Date of publication of application: 18.07.2018
(73) Proprietor: General Electric Technology GmbH, 5400 Baden (CH)
(72) Inventor: Vuachet, Jacques, 74330 Poisy (FR)
(74) Representative: Freigutpartners IP Law Firm

(56) References cited:
- CN-U- 202 758 042
- JP-A- 2009 174 894
- KR-A- 20110 007 682
- US-A1- 2014 002 099
- JUDD M D ET AL: "Broadband couplers for UHF detection of partial discharge in gas-insulated substations", IEE PROCEEDINGS: SCIENCE, MEASUREMENT AND TECHNOLOGY, IEE, STEVENAGE, HERTS, GB, vol. 142, no. 3, 1 May 1995 (1995-05-01), pages 237-243, XP002133983, ISSN: 1350-2344, DOI: 10.1049/IP-SMT:19951699
- HUAMAO ZHAN ET AL: "Study on the Disc Sensor Based on the Cavity Mold Theory", IEEE SENSORS JOURNAL, IEEE SERVICE CENTER, NEW YORK, NY, US, vol. 16, no. 13, 1 July 2016 (2016-07-01), pages 5277-5282, XP011613303, ISSN: 1530-437X, DOI: 10.1109/JSEN.2016.2554523 [retrieved on 2016-06-02]
- Anonymous: "Switchgear overpressure bursting disc", , 1 January 2009 (2009-01-01), XP055391831, Retrieved from the Internet: URL:https://www.contdisc.com/images/docume nts/DocLib_354_SwitchgearOverpressureBurst ingDiscTechnicalBrief.pdf [retrieved on 2017-07-18]

## Description

### TECHNICAL FIELD

The invention relates to the field of gas-insulated switchgears (GIS). More particularly, the invention relates to a Partial Discharge (PD) detection arrangement for a GIS. The invention also relates to a combined module for enabling such PD detection arrangements to be provided on a GIS.

### PRIOR ART

Switchgears are provided in high-voltage electrical power systems to enable downstream equipment to be de-energised and isolated so as to permit, for example, repair, maintenance, or installation of a new component. Gas-insulated switchgears (GIS) are generally preferred to other types of switchgears as they are capable of safely handling large currents and power levels while occupying a substantially smaller volume. Electrical conductors in the GIS are fitted inside tubular compartments filled with insulating gas, typically SF6 gas.

Partial discharge (PD) is a phenomenon which occurs in GIS. PD may be caused by particles, protrusions, defects in or on the inter-compartment insulators, or even a floating potential within the GIS. For example, the engagement and disengagement of circuit breaker (CB) components often results in small metal particles being shed. These metal particles then float in the insulating gas and disturb the dielectric field within the GIS. This disturbance manifests itself as a PD. The presence of the metal particle encourages a temporary discharge from the electrical conductor to jump to the metal particle and then to the compartment wall. PD occurs at various locations within the GIS, although most often within the CB compartment.

A PD may cause the GIS to function poorly, or even breakdown. The ability to detect and localise the occurrence of PD in a GIS can therefore be useful, allowing faults or breakdowns to be pre-empted and corrective measures taken. For this reason, GIS are often provided with PD detectors. External PD detectors are sometimes utilised, however these typically need to be located at a viewing window or on the peripheral part of an insulator if it is accessible. Internal PD detectors are generally preferred, as they function better being located within the same space where the PD occur, but again have to be mounted at specifically designated mounting points (openings giving access to the interior) on the GIS.

Sometimes, it becomes necessary to add PD detectors to the GIS. This may be to improve the PD detection and localisation capability, or to meet quality and safety standards. Installing additional PD detectors onto a GIS is usually expensive. PD detectors are not cheap, and the manpower required for the installation may be costly. In certain cases, this involves having to stop operation of the GIS, evacuation the insulating gas, and even the removal of sections of the GIS, all of which results in costly downtime. This is especially so where the GIS is unable to receive a PD detector at or near a point where it is required, for example, because there is no viewing window, accessible insulator or mounting point. A combined GIS rupture disc and PD detection unit is known from KR20110007682.

As such, there is clearly a need for an easier and quicker way to improve PD detection capability in a GIS. There is equally a need to be able to do this as a reduced cost, and ideally, without having to stop operation of the GIS.

### BRIEF DESCRIPTION OF THE INVENTION

The present invention provides a partial discharge (PD) detection arrangement for a gas-insulated switchgear (GIS), the arrangement comprising a PD detector comprising a monitoring device and an antenna for receiving signals from the occurrence of PD, and a rupture disc (RD) unit comprising a RD arranged to rupture when a predetermined pressure differential across the RD is exceeded, the RD arranged to be electrically isolated from direct electrical contact with the GIS, and being connected to the monitoring device such that the RD acts as the antenna of the PD detector.

The problem of having insufficient partial discharge (PD) detectors in a gas-insulated switchgear (GIS) is cleverly solved by providing an arrangement where part of a rupture disc (RD) unit is utilised as part of a PD detector. In particular, the RD of the RD unit is utilised as the antenna PD detector. Usually, every compartment of a GIS is provided with, or arranged to receive a RD unit. By utilising the RD on the RD unit as an antenna, PD detection capability can be provided at more locations on the GIS than was traditionally possible. Furthermore, the fact that RD units are almost exclusively provided as replaceable components readily attachable to and detachable from the (rest of the) GIS structure implies that such PD detection capability can also be easily and quickly provided. The invention therefore allows PD detection capability in a GIS to be significantly improved.

Preferable features of the invention are detailed in the appendant claims.

### BRIEF DESCRIPTION OF THE FIGURES

The invention will be better understood when reading the following detailed description and non-limiting examples, as well as studying the figures, wherein:
figures 1A and 1B shows a perspective view and a cross-section view respectively of a RD unit of the prior art,
figure 2 shows a cross-section view of a PD detection arrangement together with a combined RD unit and antenna module, according to a preferred embodiment of the present invention,
figure 3 shows close up view of the cross-section view in figure 2, and
figure 4 shows a cross-section view of a combined RD unit and antenna module, according to a preferred, embodiment of the present invention.

In all of these figures, identical references can designate identical or similar elements. In addition, the various portions shown in the figures are not necessarily shown according to a uniform scale, in order to make the figures more legible.

### DETAILLED DESCRIPTION OF PARTICULAR EMBODIMENTS

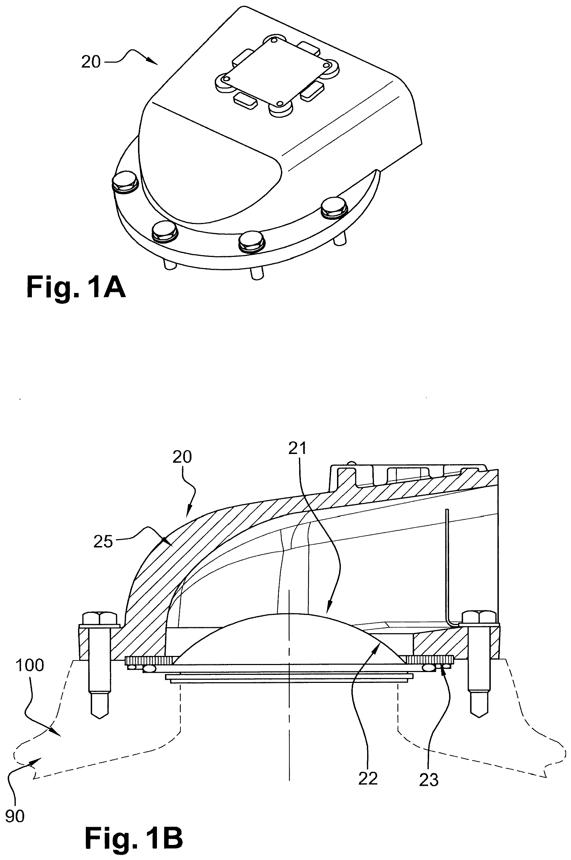

Figures 1A and 1B show a known rupture disc (RD) unit 20. The RD unit 20 has a RD 21 and a housing 25. A RD is a frangible metal membrane, which may assume various shapes, configured to rupture when a predetermined pressure differential across is exceeded. One side of the RD 21 is placed in communication with the interior of the GIS 100, such as the interior of a compartment 90, i.e. a section of the GIS which has its own volume of gas. The other side is placed in communication with the exterior of the compartment 90 or GIS 100, which is often at atmospheric pressure. The RD 21 is therefore exposed to the pressure differential between the inside and outside (atmospheric pressure) of the GIS 100. When pressure within the GIS 100 increases such that it exceeds a predetermined pressure differential, the RD 21 will rupture to vent the gas and prevent the compartment becoming over-pressurised.

The RD unit 20 can be attached to and detached from the GIS 100. The RD 21 itself may be supported by the housing 25, or by the housing 25 and a compartment 90 of the GIS 100 to which it is attached. The RD 21 in the figure comprises a central bulge 22 which is the part arranged to rupture, and a flat flange 23 surrounding the central bulge 22 by which it is supported when mounted to the GIS 100. In the RD unit 20 shown in the figure, the RD 21 is mounted to the GIS 100 by clamping the flange between the housing 25 and the compartment 90 of the GIS 100. The RD unit 20 is sealingly connected to the compartment 90.

When the RD unit 20 is installed on the GIS 100, it is in direct electrical contact with the compartment 90 of the GIS 100 which is earthed. This prevents the RD unit 20, the housing 25 or the RD 21 being a floating potential within the GIS 100 during operation. In particular, the RD 21 is in direct contact with the respective compartment 90, and is therefore earthed. The housing 25 is also earthed through its connection to the compartment 90, though it may be via a different path. The RD 21 is also in direct electrical contact with the housing 25. The RD 21 is earthed through its direct electrical contact with the GIS 100, which includes the compartment 90, and the housing 25 too as the RD unit 20 arguably makes up part of the GIS 100 when mounted thereto. As RD units are known, their general physical and functional aspects will not be discussed in further detail.

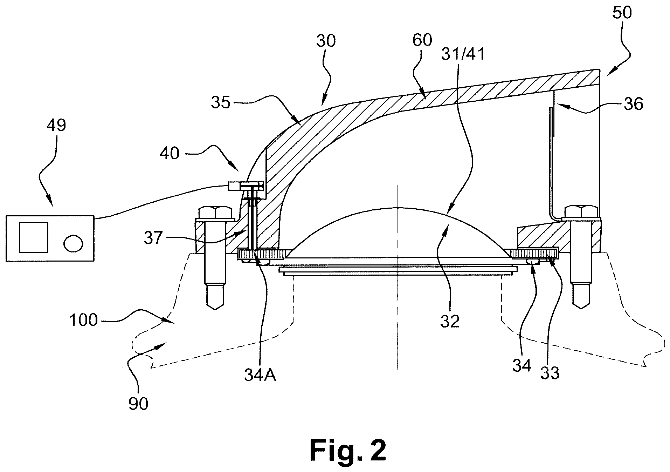

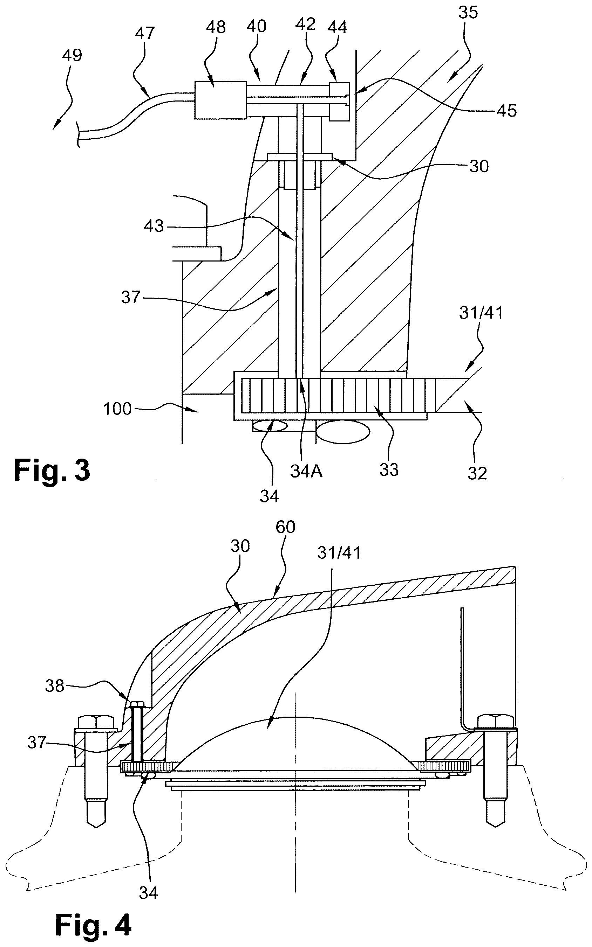

Figure 2 shows a partial discharge (PD) detection arrangement 50 according to an embodiment of the invention. The arrangement 50 is shown installed in a GIS 100. Figure 3 shows a close up view of a section of figure 2, providing further detail on the electrical connections. Note that the invention also relates to a combined RD unit and antenna module 60 for such a PD detection arrangement 50. The combined module 60 can also be seen in the figures.

The PD detection arrangement 50 comprises an RD unit 30. Apart from certain differences which will become apparent further in the description, the RD unit 30 (components and their disposition) is essentially the same as that of figure 1. However the arrangement also comprises a PD detector 40. The PD detector 40 indicates the occurrence of PD. To be able to do this, the PD detector 40 comprises an antenna 41 for receiving signals from the occurrence of PD and monitoring device 49 to process these signals to information indicating the occurrence of PD.

In the arrangement, the RD 31 acts as the antenna 41 of the PD detector 40. The monitoring device 49 of the PD detector 40 is electrically connected to the RD 31. Signals received by the RD 31 therefore can be processed by the monitoring unit 49 to indicate the occurrence of PD. The large surface area of the RD 31 makes it well suited for receiving electromagnetic signals due to PD. The RD 31 therefore not only plays a role in the safety of the GIS 100, arranged to rupture when a predetermined pressure within the GIS 100 is exceeded, it simultaneously serves as an antenna 41 of the PD detector 40. It should be noted that although the RD 31 acts as an antenna 41 for the PD detector 40, the antenna 41 of the PD detector 40 may additionally use other components to serve as an antenna. Typically however, the RD 31 forms the whole antenna 41 of the particular PD detector 40.

The RD unit 30 in most cases comprises the RD 31 and a housing 35, although may comprise just the RD 31 in certain cases. The RD 31 is mounted to the GIS 100 using the housing 35. In the embodiment shown in the figures, the housing 35 is attached to the compartment 90 such that the RD 31 is mounted between the two. An RD unit with the RD already mounted in the housing may be utilised instead. Although often described as being a separate to the GIS 100, it should be borne in mind that the RD unit 30, and the PD detector 40 too, arguably make up part of the GIS 100 when installed on it.

The RD 31 is mounted such that it is electrically isolated from direct electrical contact with the GIS 100. As mentioned earlier, as the RD unit 30 arguably makes up part of the GIS 100 when mounted thereto, this includes the housing 35, whenever present. In order for the RD 31 to function as an antenna 41, it is necessary for it to be isolated from direct electrical contact with the GIS 100, including the compartment 90 and the housing 35. This allows for a difference in potential between the RD 31 and the earthed GIS 100 to be detected to thereby identify the occurrence of PD, the RD 31 thereby acting as an antenna.

This is rather unlike the RD unit 20 of prior art figure 1, where the RD 21 is mounted in direct electrical contact with the GIS 100, amongst other reasons, to ensure it does not become a floating potential. To electrically isolate the RD 31, it is provided with isolating means 34. As shown, insulating varnish 34 could be applied to its flange 33 where it is supported by the metal housing 35 or metal compartment 90. Alternatively, insulating gaskets are installed such that the RD 31 is held spaced from the housing 35 and compartment 90 and thus electrically isolated from them. Other ways of isolating the RD 31 may instead be employed. It should be noted that although the RD 31 is electrically isolated from direct contact with the GIS 100, it does not affect the safety role of the RD unit 30.

The PD detection arrangement 50 also comprises a coaxial connector 42 with a short circuit. A coaxial connector 42 with a quarter-wave short circuit is utilised, so as to reduce signal attenuation. The coaxial connector 42 is of the known type, realised here with a T-adaptor comprising an inner conductor 43 and an outer shield 44, with a short circuit 45 provided at one end.

The coaxial connector 42 is placed so that it is in electrical contact with the RD 31. It is partly located in a bore 37 within the housing 35, extending through it until it reaches the RD 31. More specifically, the inner conductor 43 of the coaxial connector 42 is connected to the flange 33 of the RD 31, while the outer shield 44 (the casing of the T-adaptor) is connected to the housing 35 of the RD unit 30.

The RD 31 is thus electrically connected to the GIS 100 and earth, passing through the inner conductor 43 and then the outer shield 44 and then the housing 35. This therefore establishes an indirect electrical connection between the RD 31 and GIS 100. This is a single electrical path going from the RD 31 through the coaxial connector 42 to the GIS 100.

So as to allow the coaxial connector 42 to be in electrical contact with the RD 31, the flange of the RD 31 is provided with an exposed portion 34A not covered by the isolating means 34, i.e. not covered by the insulating varnish or concealed by the insulating gasket. The coaxial connector 42 extends through the bore 37 and contacts this part of the RD 31. Optionally, the inner conductor 43 may comprise a probe (not shown) and a spring (not shown), to facilitate placing the inner conductor 43 through the bore 37 and in contact with the flange 33 of the RD 31.

The monitoring device 49 is connected to the RD 31 via the coaxial connector 42. In this embodiment, a coaxial cable 47 connects the monitoring device 49 to the coaxial connector 42, the inner conductor of the coaxial cable 47 being connected to the inner conductor 43 of the coaxial connector 42, and with the outer shield of the coaxial cable being connected to the outer shield 44 of the coaxial connector 42. This allows the variation in potential between the inner cable and outer shield to be detected, and the occurrence of a PD to thereby be indicated. When a PD occurs, signals received by the RD 31 can thereby be processed by the monitoring unit 49 of the PD detector 40 to indicate the presence of PD.

It must be emphasised here that the coaxial connector 42 does not have to have a short circuit 45. The invention will still function without this. However, if the RD 31 is not earthed, the RD 31 will remains as a floating potential within the GIS 100, which not only may affect normal functioning of the GIS 100, but may also pose an electrocution risk should anyone touch the inner conductor 43 by accident. The invention would also still work if two wires not in a coaxial arrangement were used instead of a coaxial connector 42, although it would be more susceptible to noise. As such, a coaxial connector 42 with a quarter-wave short circuit is highly preferred.

The PD detector 40 preferably works in ultra-high frequency (UHF). By selecting UHF, or a band within this UHF frequency (for example 200-3000MHz), electromagnetic noise pollution present in the GIS 100, for example coming from the electrical conductor at industrial frequency (50Hz or 60Hz) and its harmonics, can be avoided as it lies outside the UHF range. The short circuit 45 is arranged such that it acts as an inductance (seen as a closed circuit) for low frequency (industrial frequency) and as high impedance (open circuit) at UHF. To further improve the PD detection arrangement 50, the RD unit 30 may be arranged with a Faraday cage 36. This reduces electromagnetic interference by protecting the RD 31 from external perturbations, for example those coming from a mobile phone, and limiting the attenuation of the signal from the RD 31.

The invention therefore is able to provide a PD detection arrangement 50 in a GIS 100 by making use of RD units 30. With RD units 30 being provided in virtually every compartment 90, and being readily replaceable, PD detection arrangements 50 can be easily provided at more locations on the GIS 100, and so the PD detection and localisation capability can be readily improved. Furthermore, with the RD 31 located in communication with the interior of the GIS 100, the PD detection arrangement 50 effectively works as an internal PD detector.

The PD detection arrangement 50 of the invention can be provided at various stages of construction of the GIS 100. For example, the arrangement 50 may be provided at the start, during installation of the GIS 100. Alternatively, existing RD units 20 may be replaced, or even retrofitted, so as to additionally provide a PD detection arrangement 50. Furthermore, the combined RD unit and antenna module 60 also makes it easier to provide a PD detection arrangement 50 in a GIS 100. Such a combined module 60 can serve as a RD unit in a GIS, and be readily adapted to be additionally used in a PD detector arrangement.

Figure 4 also shows an example of the combined module 60 of the invention in one of the more basic forms. It is adapted to be readily reconfigured to be used as an antenna 41 in a PD detection arrangement 50 for a GIS 100. It comprises a RD unit 30 with a RD 31 and a housing 35, somewhat similar to the prior art in figure 1, but the RD 31 is arranged to be mounted so as to be electrically isolated from direct electrical contact with the GIS 100. In particular, insulating varnish 34 has been applied to the flange 33 of the RD 31. Of course, an insulating gasket, or other isolating means may instead be provided. The RD 31 of the combined module 60 is also arranged to electrically connect to a monitoring device 49 of a PD detector 40 such that the RD 31 acts as the antenna 41 of the PD detector 40. In particular, the housing 35 comprises a bore 37 leading to the RD 31, arranged to receive a coaxial connector 42 such that it can be placed in electrical contact with the RD 31.

Essentially as discussed in relation to the PD detection arrangement 50, when this combined module 60 is mounted on the GIS 100, the RD 31 will be isolated from direct electrical contact with the GIS 100. Meanwhile, a coaxial connector 42 will be inserted in the bore 37 to be in electrical contact with the RD 31. A monitoring device 49 of a PD detector 40 will then be electrically connected to the RD 31 via the coaxial connector 42 so that the RD 31 acts as the antenna 41 of the PD detector 40. Other physical and functional aspects of the combined module 60 are evident from the discussion relating to the PD detection arrangement 50, and so will not be specifically repeated here.

In figure 4, the bore 37 of the combined module 60 is shown with a conductor element 38, in the form of a screw. The screw 38 extends through the bore 37 and electrically connects the RD 31 and the housing 35, so that the RD 31 does not become a floating potential when the combined module 60 is utilised solely as a RD unit. When the combined module 60 is to be reconfigured to additionally act as PD detector 40, the screw 38 is removed and a coaxial connector 42 inserted. If this combined module 60 is already attached to the GIS 100, the GIS 100 may have to be shut down, otherwise the RD 31 may become a floating potential between removing the screw 38 and inserting the coaxial connector 42 and thereby pose an electrocution risk.

So as to avoid having to shut down the GIS 100, two bores 37 are preferably provided, with one comprising a conductor element 38 such as a screw in contact with the RD 31, and the-other arranged to receive a coaxial connector 42. When the combined module 60 is to be utilised in a PD detection arrangement 50, a coaxial connector 42, preferably a coaxial connector 42 with a quarter-wave short circuit, will be inserted until it is in contact with the RD 31, and only then the screw 38 of the combined module 60 removed. In this way, the risk of electrocution or breakdown is removed, and the coaxial connector 42 can be attached to a combined module 60 installed in a GIS 100 even when the GIS 100 is operational. The removal of the screw 38 then leaves the coaxial connector 42 as the only path between the RD 31 and the GIS 100. Of course, the combined module 60 may be provided with the coaxial connector 42 already installed.

The current invention advantageously facilitates certain quality and safety criteria to being met by GIS, for example to obtain standards certification. One such criteria is that an occurrence of a PD must be detected by at least two PD detectors (or the antennas thereof). With the current invention, PD detection arrangements 50 can be mounted readily and at more locations than was traditionally possible, in fact wherever RD units 30 can be provided. Accordingly, the invention makes it easier for this criteria to be met.

As an exception, the criteria above does not have to be met (i.e. that only one PD detector detects the PD) if, during commissioning, it can be shown that a pulse injected from an intermediate detector will be picked up by two adjacent detectors. This would demonstrate that a particular area is indeed covered by the adjacent detectors. In most cases, GIS do not have the ability to place a traditional PD detector at the intermediate location. However, with the present invention, a PD detection arrangement 50 may be installed at a mounting point for a RD unit (at or close to an intermediate location) to inject the pulse and to satisfy the requirements at commissioning, and subsequently removed. This may permit the number PD detectors in a GIS to be reduced, while still meeting the standards criteria.

It will be understood that the PD detection arrangement 50 will work so long as the RD 31 is not ruptured. Once the RD 31 is ruptured, the PD detection arrangement 50 will not work until the RD 31 is replaced and the insulating gas refilled. It will be obvious to the skilled person that the antenna 41 of the PD detector 40 while being a receiver, will also be capable of acting as a transmitter. The PD detector 40 may be arranged to transmit as well as receive.

## Claims

1. A partial discharge (PD) detection arrangement for a gas-insulated switchgear (GIS), the arrangement (50) comprising
- a PD detector (40) comprising a monitoring device (49) and an antenna (41) for receiving signals from the occurrence of PD, and
- a rupture disc (RD) unit (30) comprising a RD (31) arranged to rupture when a predetermined pressure differential across the RD (31) is exceeded, **characterised in that** the RD (31) is arranged to be electrically isolated from direct electrical contact with the GIS, and **in that** it is connected to the monitoring device such that the RD (31) simultaneously serves as antenna of the PD detector (40).

2. An arrangement (50) according to claim 1, wherein the RD unit (30) comprises a housing (35), the housing (35) arranged to be attached to the GIS so as to mount the RD (31) onto the GIS.

3. An arrangement (50) according to one of claims 2, wherein the PD detector (40) comprises a coaxial connector (42), the coaxial connector (42) being in electrical contact with the RD (31).

4. An arrangement (50) according to claim 3, wherein the coaxial connector (42) is a coaxial connector with a quarter-wave short circuit.

5. An arrangement (50) according to claim 4, wherein the inner conductor (43) of the coaxial connector (42) is in electrical contact with the RD (31), and the outer shield (44) is in electrical contact with the housing (35).

6. An arrangement (50) according to claim 3, 4, or 5, wherein the housing (35) comprises a bore (37), and the coaxial connector (42) is connected to the RD (31) through the bore (37).

7. A GIS (100) comprising an arrangement (50) according to any preceding claim.

## Patentansprüche

1. Teilentladungs- (TE) Detektionsanordnung für eine gasisolierte Schaltanlage (GIS), wobei die Anordnung (50) umfasst
- einen TE-Detektor (40), der eine Überwachungsvorrichtung (49) und eine Antenne (41) zum Empfangen von Signalen aus dem Auftreten einer TE umfasst, und
- eine Berstscheiben- (BS) Einheit (30), die eine BS (31) umfasst, welche so angeordnet ist, dass sie birst, wenn eine vorbestimmte Druckdifferenz über die BS (31) überschritten wird, **dadurch gekennzeichnet, dass** die BS (31) so angeordnet ist, dass sie elektrisch von direktem elektrischem Kontakt mit der GIS isoliert ist, und dadurch, dass sie derart mit der Überwachungsvorrichtung verbunden ist, dass die BS (31) gleichzeitig als Antenne des TE-Detektors (40) dient.

2. Anordnung (50) nach Anspruch 1, wobei die BS-Einheit (30) ein Gehäuse (35) umfasst, das Gehäuse (35) dazu angeordnet, an der GIS angebracht zu werden, um die BS (31) an der GIS zu montieren.

3. Anordnung (50) nach einem der Ansprüche 2, wobei der TE-Detektor (40) einen Koaxialverbinder (42) umfasst, wobei der Koaxialverbinder (42) mit der BS (31) in elektrischem Kontakt steht.

4. Anordnung (50) nach Anspruch 3, wobei der Koaxialverbinder (42) ein Koaxialverbinder mit einem Viertelwellen-Kurzschluss ist.

5. Anordnung (50) nach Anspruch 4, wobei der Innenleiter (43) des Koaxialverbinders (42) mit der BS (31) in elektrischem Kontakt steht, und der Außenabschirmung (44) mit dem Gehäuse (35) in elektrischem Kontakt steht.

6. Anordnung (50) nach Anspruch 3, 4, oder 5, wobei das Gehäuse (35) eine Bohrung (37) umfasst, und der Koaxialverbinder (42) durch die Bohrung (37) hindurch mit der BS (31) verbunden ist.

7. GIS (100), die eine Anordnung (50) nach einem der vorstehenden Ansprüche umfasst.

## Revendications

1. Aménagement de détection de décharge partielle (DP) pour un appareillage de commutation isolé au gaz (ACIG), l'aménagement (50) comprenant
- un détecteur de DP (40) comprenant un dispositif de surveillance (49) et une antenne (41) pour recevoir des signaux à partir de l'apparition de DP, et
- une unité (30) de disque de rupture (DR) comprenant un DR (31) agencé pour se rompre quand une différence de pression prédéterminée à travers le DR (31) est dépassée, **caractérisé en ce que** le DR (31) est agencé pour être isolé électriquement d'un contact électrique direct avec l'ACIG, et **en ce qu'**il est connecté au dispositif de surveillance de telle sorte que le DR (31) sert simultanément d'antenne du détecteur de DP (40).

2. Aménagement (50) selon la revendication 1, dans lequel l'unité DR (30) comprend un boîtier (35), le boîtier (35) étant agencé pour être fixé à l'ACIG de manière à monter le DR (31) sur l'ACIG.

3. Aménagement (50) selon l'une des revendications 2, dans lequel le détecteur de DP (40) comprend un connecteur coaxial (42), le connecteur coaxial (42) étant en contact électrique avec le DR (31).

4. Aménagement (50) selon la revendication 3, dans lequel le connecteur coaxial (42) est un connecteur coaxial avec un court-circuit en quart d'onde.

5. Aménagement (50) selon la revendication 4, dans lequel le conducteur interne (43) du connecteur coaxial (42) est en contact électrique avec le DR (31), et le blindage externe (44) est en contact électrique avec le boîtier (35).

6. Aménagement (50) selon la revendication 3, 4 ou 5, dans lequel le boîtier (35) comprend un alésage (37), et le connecteur coaxial (42) est connecté au DR (31) à travers l'alésage (37).

7. ACIG (100) comprenant un aménagement (50) selon l'une quelconque des revendications précédentes.
